# EUROPEAN PATENT APPLICATION

(11) **EP 3 499 566 A1**
(43) Date of publication of application: **19.06.2019**
(21) Application number: 18211264.9
(22) Date of filing: 10.12.2018
(51) Int. Cl.: H01L 23/495, H01L 23/552

(54) **EMC PROTECTION OF A SEMICONDUCTOR COMPONENT**

(30) Priority: 13.12.2017 FI 20176113
(71) Applicant: Murata Manufacturing Co., Ltd., Kyoto 617-8555 (JP)
(72) Inventor: Kaija, Kimmo, 02660 Espoo (FI); Nurmi, Sami, 04320 Tuusula (FI); Tuomikoski, Santeri, 02620 Espoo (FI); Brachkov, Hristo, 01700 Vantaa (FI)
(74) Representative: Boco IP Oy Ab

(57) **Abstract**

The present invention relates to a semiconductor assembly comprising a semiconductor package. An essentially planar portion of a die attach paddle is disposed above the at least semiconductor die. The essentially planar portion forms a plane of the die attach paddle. The area of the essentially planar portion is greater than that of a combined area of an orthogonal projection of the at least one semiconductor die on the plane of the die attach paddle. The essentially planar portion of the die attach paddle is coupled via at least two bond pads to at least two first leads of the lead-frame. The at least two first leads are configured to be coupled to a ground potential so that the essentially planar portion of the die attach paddle forms a first ground plane inside the semiconductor package above the at least one semiconductor die. A second ground plane electrically coupled to the at least two first leads is disposed on the face of the printed circuit board that resides towards the semiconductor package. The second ground plane is coplanar with the plane of the die attach paddle, and disposed under the body of the semiconductor package

## Description

### Field

The present invention relates to a semiconductor package and a semiconductor assembly related to electromagnetic compatibility (EMC). More particularly, the invention relates to a semiconductor assembly for reducing susceptibility of a MEMS assembly towards electromagnetic emissions.

### Background

Emission refers to generation of electromagnetic energy by some source and its release into the environment. Susceptibility refers to the tendency of electrical equipment, referred to as the victim, to malfunction or break down in the presence of unwanted emissions. Coupling refers to the mechanism by which emitted interference reaches the victim.

Electromagnetic compatibility (EMC) studies the unwanted emissions and the countermeasures which may be taken in order to reduce unwanted emissions.

A die paddle, also known as a die attach paddle or DAP, is a thin structure of electrically conducting material within a packaged integrated circuit to which a die is attached and which in turn is attached to a lead frame. The conductive material of the die paddle may be metal. A die paddle may be connected to a defined DC potential, such as ground.

Micro-Electro-Mechanical Systems, or MEMS, can be defined as miniaturized mechanical and electro-mechanical systems where at least some elements have a mechanical functionality. Since MEMS devices are created with the same or similar tools used to create integrated circuits, micromachines and microelectronics can be fabricated on the same piece of silicon.

MEMS devices comprising structures can be applied to quickly and accurately detect very small changes in physical properties. For example, a microelectronic gyroscope can be applied to quickly and accurately detect very small angular displacements, and a microelectronic accelerometer can be applied to detect acceleration.

MEMS devices may be applied for detecting physical properties in harsh environments. For example, MEMS devices may be used for detecting acceleration or angular displacement in vehicles, such as automotive or aeroplanes. The environment is not only mechanically harsh, but also prone to introduce various electromagnetic emissions, which may affect performance of the MEMS device.

### Description of the related art

Various methods are used for protecting sensitive circuitry, such as semiconductor components. Semiconductor package may be covered with a metal sheet or screen, which forms a shield for emissions from outside the component. The shield may be electrically connected to ground potential for effective shielding.

US patent 6,611,048 discloses an exposed paddle that may be connected to ground of a printed circuit board during a re-flow solder process. Although the exposed paddle may also protect the dies from emissions from under the package body, the semiconductor dies remain unprotected from emissions from above the package body.

US patent 7,960,818 discloses a shield applied above a package body of a semiconductor package.

A problem of the above solution is that placing a shield requires additional parts and also additional steps in an assembly process.

### Summary

An object is to provide a semiconductor package and a semiconductor assembly so as to solve the problem of mitigating electromagnetic susceptibility by enabling protecting the dies residing inside a semiconductor package even with a simplified assembly process. The objects of the present invention are achieved with a semiconductor assembly according to the characterizing portion of claim 1.

The preferred embodiments of the invention are disclosed in the dependent claims.

The present invention is based on the idea of improving electromagnetic compatibility of a semiconductor device disposed in a semiconductor package that is installed on a printed circuit board (PCB) by introducing a combination of a grounded die attach paddle forming a first ground plane inside the semiconductor package for protecting the semiconductor device against emissions from above, and a second ground plane disposed on the PCB under the semiconductor package for protecting the semiconductor device against emissions from below. The semiconductor dies of the semiconductor device are sandwiched between the two ground planes, on residing inside the semiconductor package and one on the PCB outside the semiconductor package. The two ground planes are electrically combined through at least one lead of the semiconductor package.

According to a first aspect, a semiconductor assembly is provided, comprising a semiconductor package installed on a face of a printed circuit board.

The semiconductor package comprises a non-conductive body, at least one semiconductor die, an electrically conducting die attach paddle, and a lead-frame comprising at least two bond pads extending through the outer surface of the body as electrically conductive leads, the leads configured to be attached to an underlying printed circuit. The at least one die and the die attach paddle are disposed within the volume of the body.

An essentially planar portion of the die attach paddle disposed on the side of the at least one semiconductor die that is away from the face of the printed circuit board on which the semiconductor package is installed. The essentially planar portion forms a plane of the die attach paddle, and the area of the essentially planar portion is greater than that of a combined area of an orthogonal projection of the at least one semiconductor die on the plane of the die attach paddle.

The essentially planar portion of the die attach paddle is coupled via at least two bond pads to at least two first leads of the lead-frame. The at least two first leads are configured to be coupled to a ground potential so that the essentially planar portion of the die attach paddle forms a first ground plane inside the semiconductor package above the at least one semiconductor die.

The printed circuit board comprises a plurality of pin pads configured to join the leads electrically and mechanically to the printed circuit board, and a second ground plane electrically coupled to the at least two first leads. The second ground plane is disposed on the face of the printed circuit board that resides towards the semiconductor package and it is coplanar with the plane of the die attach paddle. A first part of the second ground plane is disposed under the body of the semiconductor package.

According to a second aspect, the area of the first part of the second ground plane covers at least a majority of the area of an orthogonal projection of the semiconductor package body on the essentially planar printed circuit board.

According to a third aspect, the shape of the first part of the second ground plane is essentially similar to the shape of the orthogonal projection of the body of the semiconductor package on the essentially planar printed circuit board.

According to a fourth aspect, the first part of the second ground plane extends outside of the area covered by the projection of the body of the semiconductor package on at least one side of the semiconductor package, which at least one side has no leads.

According to a fifth aspect, the second ground plane further comprises at least two extensions configured to provide at least two pin pads for coupling the at least two first leads to the second ground plane.

According to a sixth aspect, the at least one semiconductor die comprises at least one MEMS die.

The present invention has the advantage that the assembly avoids need for a separate grounded cap structure for EMC. The assembly process is simplified from that of assembling a grounded cap structure, without compromising the electromagnetic compatibility of the sensitive semiconductor device residing within the semiconductor package. Required level of EMC is achieved simply by installing the semiconductor device residing in a suitably designed semiconductor package on the PCB using a standard soldering method.

### Brief description of the drawings

In the following the invention will be described in greater detail, in connection with preferred embodiments, with reference to the attached drawings, in which
Figure 1 is an illustration of a semiconductor package disposed on a PCB.
Figures 2a, 2b and 2c illustrate an intersection of the semiconductor package installed on a PCB 200 along an yz-plane.
Figures 3a and 3b illustrate a metal pattern disposed on a top face of a PCB.
Figure 4 further illustrates a three-dimensional view of a component package.

### Detailed description

In this application, an xy-plane may be defined by a plane of an essentially planar PCB, and the z-axis orthogonal to the xy-plane traverses the xy-plane. We may refer to this xy-plane as the plane of the PCB. An essentially planar portion of a die attach paddle may define another plane coplanar with the plane of the PCB. We may refer to this plane defined by an essentially planar portio of a die attach paddle as the plane of the die attach plane. Either of the above planes may be used as a reference plane.

The term horizontally refers to any direction along the xy-plane or along a plane coplanar with the xy-plane, and the term vertically refers to direction orthogonal with the xy-plane, along an axis collinear with the z-axis. The term up, top, above and like refer to a direction along the positive z-axis, whereas the term bottom, down, below and like refer to a direction along the negative z-axis. For example, a component package is assumed to be installed on the top face of a PCB so that the leads to be joined to the PCB may be referred to as pointing down towards the PCB.

The term "collocated" refers to relative location of two physical objects, which may reside on different height from a reference plane, and defines that the objects or the projection of the objects on the reference plane at least partially overlap. Preferably, term collocated refers to a situation in which majority of the area of a first object and area of the projection of a second object on the reference plane overlap.

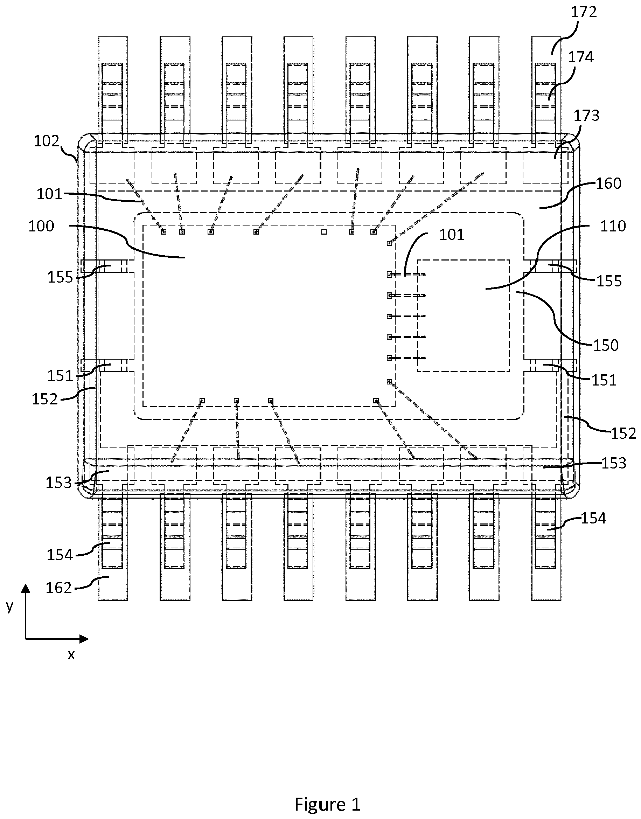

The figure 1 shows a top view of a semiconductor package disposed on a PCB. In other words, the figure 1 shows a projection of the semiconductor package installation in the xy-plane. The semiconductor package comprises a body 102, a lead-frame comprising a number of leads 154, 174 extending from bond pads 153, 173. The projected outline of the semiconductor package body 102 is indicated with a solid line forming a rectangle with rounded corners. The semiconductor package comprises at least one semiconductor die. This exemplary package comprises a first semiconductor die 100 and a second semiconductor die 110. Electrical connections between the first and second semiconductor dies (100, 110) and between the first semiconductor die and at least some of the bond pads 173 are provided in this exemplary embodiment by bond wires 101. However, electrical connections between the semiconductor dies and between the semiconductor dies and the leadframe may be implemented using any known technology suitable for the task.

The first and second semiconductor dies (100, 110) are attached to a die attach paddle with adhesive means (not shown). The die attach paddle is preferably made of a thin metal sheet. The die attach paddle comprises an essentially planar portion 150 configured for attaching the semiconductor. The essentially planar portion is preferably uniform and monolithic. In this example, the essentially planar portion is formed as a quadrangle/rectangle with rounded corners. The die attach paddle may further comprise extension portions 151, 155. The extension portions may also be called tie bars. At least one of first extension portions 151 may be electrically coupled to a first bond pad 153. The extension portions 151, 155 may be bent if needed for establishing a mechanical form from the die attach paddle and the attached semiconductor dies that fits in the semiconductor package body. As known by a skilled person in the art, the extension portions 151, 155 serve as a mechanical coupling between an external part of the lead frame and the planar portion 150 of the die attach paddle during assembly process of the semiconductor package. The external part of the lead frame is eventually cut off during the manufacturing process, but the extension portions 151, 155 remain inside the semiconductor package, coupled with the planar portion 150 of the die attach paddle. The electrical coupling between the first extension portion 151 and the first bond pad 153 may be provided by any known electrical connection means. In the exemplary embodiment, the coupling is implemented by a coupling metal portion 152 formed from the same metal sheet that forms the die attach paddle and the first bond pad 153, allowing the entire structure to be patterned from a single metal sheet. Such coupling provided a single combined patterned metal sheet comprising die attach paddle's planar portion 150 and first extension portion 151, the coupling metal portion 152 and the first bond pad 153 provides a low resistance electrical coupling that is simple to manufacture and mechanically robust. The patterning may comprise also three-dimensional bending of the metal sheet, especially the extension portions 151, 153. In the disclosed embodiment, the first extension portions 151 are bent down (towards the negative z-axis) from the plane defined by the planar portion 150 of the die paddle towards the bottom of the package, in other words towards the underlying PCB when the semiconductor package is installed on the PCB. The semiconductor dies 100, 110 are thus disposed under the planar portion 150. In a variation of the structure, the electrical coupling between the first extension portion 151 and the first bond pad 153 may be provided that has a higher resistance than a coupling metal portion 152 formed by the same metal sheet with the die attach paddle and the first bond pad 153.

In an alternative embodiment, there are no extension portions in the planar portion 150 of the die attach paddle. Independent on whether there are extension portions or not, the first bond pad 153 may also be coupled with the planar portion 150 directly, without using the first extension portion 151 as part of the coupling connector structure. The coupling may be implemented by a coupling metal portion disposed between the essentially planar portion 150 of the die attach paddle and the first bond pad 153.

Figure 1 further illustrates an outline of a metal pattern disposed on a face of a PCB that faces towards the installed semiconductor package. This pattern comprises pin pads 162, 172 configured for soldering the leads 154, 174 of the component package with the PCB. The pattern further comprises a ground plane 160 facilitating EMC. This pattern on the PCB will be illustrated in more detail later.

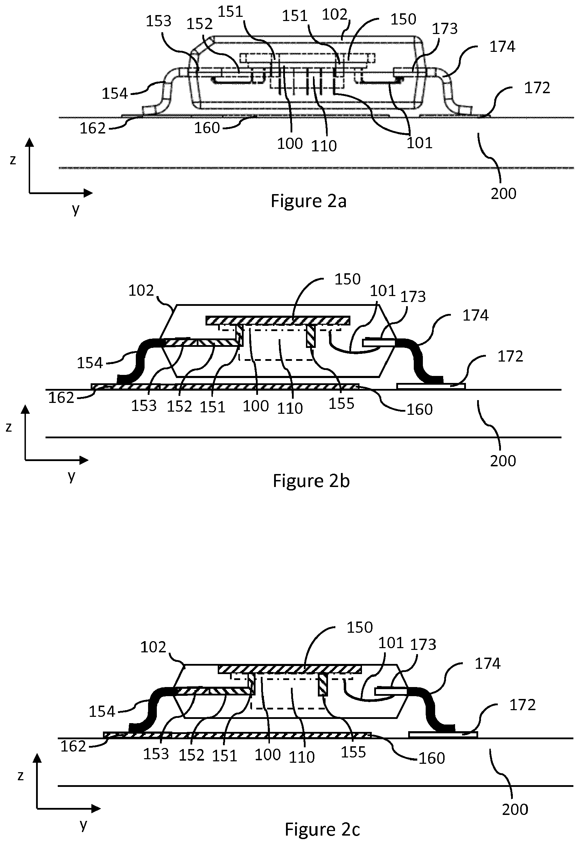

Figures 2a to 2c illustrate intersections of the semiconductor package installed on a PCB 200 along an yz-plane. Figure 2a includes more details, while figure 2b is a simplified illustration of the same intersection omitting for example bond wires 101, for clarity. Figure 2c schematically illustrates a semiconductor package with exposed paddle on the top face of the package body 102. Figures 2b and 2c are not in scale, but certain parts have been exaggerated for clarity.

The component body is installed on a surface of a PCB 200. The leads 154, 174 are configured to be attached to pin pads 162, 172 patterned on the top surface of the PCB 200. Also, a second ground plane 160 is patterned on the top surface.

The component body comprises the die attach paddle comprising an essentially planar portion 151 and extension portions 151, 155. This perspective shows that the extension portions 151, 155 are bent in this embodiment. Need for bending the extension portions depends at least on the type and size of the semiconductor package, vertical dimensions of the semiconductor dies 100, 110 and needed space for the bond wires 101. The entire planar portion 150 of the die attach paddle is preferably disposed within the volume of the body 102. In some embodiments, the planar portion 150 may be enclosed in its entirety inside the body as illustrated in the embodiments of Fig. 2a and 2b. In some embodiments, the upper face of the planar portion 150 of the die attach paddle may also be exposed at the top face or the package body 102 as illustrated in the Fig. 2c. The semiconductor dies 100, 110 are attached to the essentially planar portion 150 of the die attach paddle. At least one first extension portion 151 of the die attach paddle is coupled to a first bond pad 153. In this example, a coupling metal portion 152 couples the extension portion 151 with the respective first bond pad 153. In addition to providing a low resistance electrical connection, the coupling metal portion 152 provides a robust mechanical coupling between the die attach paddle and the first bond pad. In addition to providing a robust plane for mechanical assembly of the semiconductor dies 100, 110, the essentially planar portion 150 of the die attach paddle is also configured to protect the semiconductor dies 100, 110 from electromagnetic emissions received from above the component body. The die attach paddle, especially the essentially planar portion 150 of the die attach paddle forms a first ground plane above the semiconductor dies 100, 110.

At least one first lead 154 electrically coupled with the die attach paddle is configured to be joined to first pin pads 162 by soldering. Second leads 174 are configured to provide electrical connections between the semiconductor chips and the PCB when joined to the pin pads 172. A bond wire 101 connects a pin pad 172 to a chip pad of one of the semiconductor dies 100, 110. The first pin pads 162 are coupled to the second ground plane 160 disposed under the semiconductor component body 102. The second ground plane 160 attached to ground potential is configured protect the semiconductor dies 100, 110 from electromagnetic emissions received from below the component body. For example, electromagnetic emissions from below the component body may be caused by signal lines embedded in the underlying PCB (not shown). The at least one lead 154 couples the bond pad 153, the coupling metal portion 152 and the entire die attach paddle structure (151, 152) to the same ground potential with the second ground plane 160.

In the figure 2b, the main parts coupled to the ground potential are indicated by shading. These include the die attach paddle including the essentially planar portion 150 and the extension portions 151, 155, the coupling metal portion 152, the lead-frame including the first bond pad(s) 153 and the first leads 154, as well as the second ground plane 160 and the first pin pads 162.

When compared to an assembly with a grounded cap structure, a skilled person notices that the assembly comprising a grounded die attach paddle and an underlying second ground plane 160 does not fully surround the semiconductor dies 100, 110, but the semiconductor dies are rather sandwiched between two essentially coplanar ground planes coupled together from at least two different points at the side(s) of the ground planes. However, the inventors have found that in many applications, there is no need to fully surround the dies into a Faraday cage type structure for achieving sufficient protection from electromagnetic emissions. However, the invention may also be implemented in a semiconductor package with leads on four sides of the package. In such case, it is possible to increase the amount first leads 154 on each side of the semiconductor package so that the semiconductor dies 100, 110 are effectively enclosed in a Faraday cage formed by the planar portion 150 of the die attach pad, the second ground plane 160 and a plurality of coupling metal portions 152 and first leads 154 between the two ground planes.

A structure with two interconnected coplanar ground planes may allow certain frequency electromagnetic signals to resonate between the planes. Effectively, the structure may be characterized as a RLC circuit, in other words a circuit consisting of a resistor (R), an inductor (L) and a capacitor (C). The physical phenomenon may be called as a RLC resonance and the resonance frequency thereof may be called a RLC resonance frequency. The electrical characteristics, especially the resistance and inductance of the coupling between the two planes affects this RLC resonance frequency. A higher resistance of the die attach paddle-lead coupling increases losses in the circuitry and thus reduces strength of the resonance. On the other hand, a low resistance structure, such as the one shown in figure 1 in which the die attach paddle, the grounding bond pads 153 of the lead-frame and the interconnections thereof are formed by a single, patterned sheet of metal, may provide a mechanically robust solution that has sufficient electrical characteristics for the application at hand.

The amount and location of couplings between the second ground plane 160 and the grounded die attach paddle forming the first ground plane affect the RLC resonance frequency. The inventors have noticed that coupling the two ground planes in only one point causes the structure to have a strong LRC resonance frequency, which is difficult to adjust, and which may be harmful to the circuitry between the ground planes that they are supposed to protect. Coupling the ground planes at least in two different locations increases the RLC resonance frequency as compared to coupling in only one location. Thus, using two or more ground connections between the two ground planes enables adjustment of both the EMC protection level and frequency of the LRC resonance.

In an environment where frequencies of likely emissions are predictable, adjustment of the possible RLC resonance frequencies simply by amount of points of coupling between the two grounded planes may provide sufficient measures to effectively protect the semiconductor dies from emissions. More than two points of coupling may be used, and the points of coupling may be chosen freely to ensure that the RCL resonance frequency of the structure is such that is not likely to occur in the normal use environment, and to achieve the wanted level of EMC protection, in other words wanted level of protection from unwanted coupling of signals external of the structure.

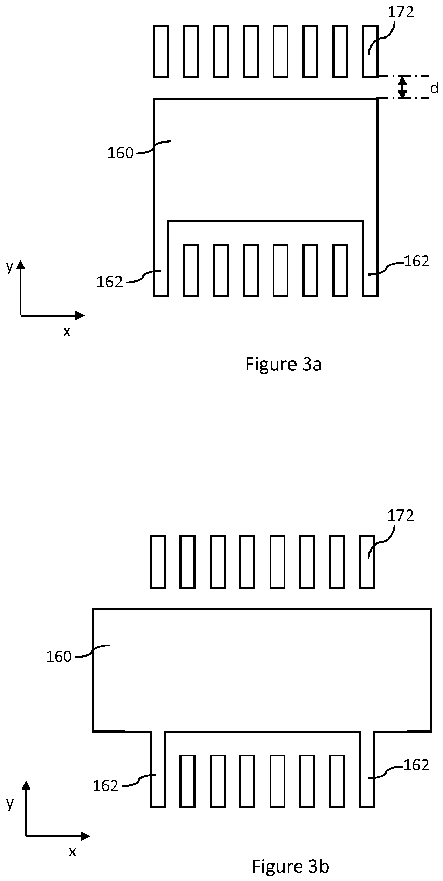

Figures 3a and 3b illustrate metal patterns disposed on a top face of a PCB, that is aligned towards the intended placement of a semiconductor package. The second ground plane 160 is coupled to first pin pads 162. In this example, two first pin pads 162 are provided that are disposed as extensions from the otherwise essentially quadrangle second ground plane 160. In this exemplary embodiment, the two first pin pads 162 extend from two adjacent corners of the second ground plane 160. However, any number of first pin pads 162 may be provided in any location corresponding to a lead of the component package. Further pin pads 172 are configured to be coupled to legs providing electrical connections towards the semiconductor chips inside the component package. As understood by a skilled person, pin pads 162, 172 are preferably further be electrically coupled on the PCB.

The body 102 and thus also the essentially planar portion 150 of the die attach paddle within the body is collocated with the second ground plane 160. The area the second ground plane 160 preferably covers majority of the area covered by an orthogonal projection of the body 102 of the semiconductor package on the plane of the PCB. The shape of the second ground plane 160 may follow the shape of the semiconductor package: the second ground plane 160 under a typical, essentially quadrangle body 102 may also be essentially quadrangle. In this connection, the shape and the area of the body 102 refer to a shape and an area of an orthogonal projection of the outline of the body 102 on a plane that is essentially coplanar with an underlying, essentially planar PCB on which the component package may be assembled. The area of the second ground plane 160 may even be greater than that of the body 102. For example, the second ground plane 160 may extend outside the area of the body on a side of the in which there are no leads in the body. Dimensions of the second ground plane 160 on the plane of the PCB may be limited by a minimum distance 'd' required to the pin pads 172. The minimum distance may depend for example on the component package type, the PCB type and the soldering process used in assembly of components on the PCB. The minimum distances are set for ensuring that the electrical connections between the leads and the pin pads are reliable and no unwanted short circuits are created between the pin pads 172 and the ground plane during the soldering process. In a quadrangle semiconductor package having pins disposed on two sides of the package body, the second ground plane 160 may extend outside the intended package body location on one or two sides on which there are no leads 154, 174 to be joined to the PCB. An example of such extended second ground plane 160 is illustrated in the Figure 3b.

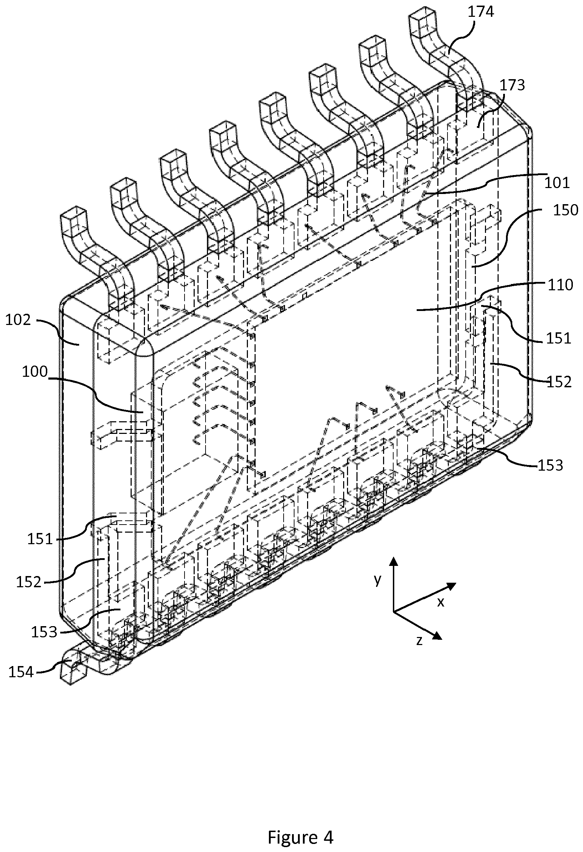

Figure 4 further illustrates a three-dimensional view of a component package according to an embodiment of the invention. The first and second semiconductor dies 100, 110 are attached to the essentially planar portion 150 of the die attach paddle. The essentially planar portion 150 of the die attach paddle is disposed vertically (along the z-axis) in a position above the semiconductor dies, in other words the die attach paddle is disposed on the opposite side of the semiconductor dies from the side of the component package configured for attachment of the leads on a PCB. Electrical signals inside the component package body 102 may be coupled through bond wires 101. The extension portions 151 of the die attach paddle may be bent. In this embodiment, two extension portions 151 are coupled to first leads 154 by coupling metal portions 152 to two first bond pads 153 respectively. The first bond pads 153 are part of a lead frame comprising multiple leads 154, 174. Signal-bearing leads and leads providing electrical connections to the semiconductor dies 100, 110, are coupled to second bond pads 173. The semiconductor dies 100, 110 and the die attach paddle are entirely enclosed into package body material. Also, the bond pads 153, 173 are disposed within the volume of the package body, whereas he leads 154, 174 of the lead-frame extend from the bond pads 153, 173 to outside the body 102, providing electrical connections for the parts disposed inside the package body 102.

In the exemplary embodiment, the semiconductor device is a MEMS device. A MEMS device may comprise a MEMS die and a signal processing ASIC configured to digitally process analog signals of the MEMS die and to communicate digital signals to external circuitry. The invention is particularly beneficial with a MEMS device. Signals provided by the MEMS die may comprise relatively weak analog detection signals representing motion of the movable parts of the MEMS die. The analog detection signals provided by the MEMS die may be carried inside the semiconductor package to the signal processing ASIC die over bond wires. Length of the bond wires may vary depending on the layout of the semiconductor dies and their placement inside the component package. The longer the bond wires, the more sensitive they typically are to unwanted coupling. However, the analog detection signals need to be detected and analyzed with high accuracy. Any coupling of unwanted signal with these sensitive analog detection signals may result in significant degradation in the accuracy of detection obtained by the MEMS device, as the signal processing ASIC is not able to distinct between the actual detected signal and the possible coupled signal or interference from outside the component package. The invented solution thus enables protecting the sensitive analog detection signals from external electromagnetic interference and thus facilitates improvement of the accuracy of detection of angular displacement and/or acceleration achieved with the MEMS device.

However, the solution may be applied to any semiconductor devices in an environment where electromagnetic compatibility is required, but a sufficient degree of EMC may be achieved with the simplified assembly comprising two interconnected ground planes, one formed by a grounded die attach paddle inside the component body and one at the surface of the underlying PCB.

It is apparent to a person skilled in the art that as technology advanced, the basic idea of the invention can be implemented in various ways. The invention and its embodiments are therefore not restricted to the above examples, but they may vary within the scope of the claims.

## Claims

1. A semiconductor assembly comprising a semiconductor package installed on a face of a printed circuit board, the semiconductor package comprising:
- a non-conductive body;
- at least one semiconductor die disposed within the volume of the body;
- an electrically conducting die attach paddle disposed within the volume of the body; and
- a lead-frame comprising at least two bond pads extending through the outer surface of the body as electrically conductive leads, the leads configured to be attached to an underlying printed circuit;
wherein an essentially planar portion of the die attach paddle disposed on the side of the at least one semiconductor die that is away from the face of the printed circuit board on which the semiconductor package is installed, wherein the essentially planar portion forms a plane of the die attach paddle, wherein the area of the essentially planar portion is greater than that of a combined area of an orthogonal projection of the at least one semiconductor die on the plane of the die attach paddle, wherein the essentially planar portion of the die attach paddle is coupled via at least two bond pads to at least two first leads of the lead-frame, and wherein the at least two first leads are configured to be coupled to a ground potential so that the essentially planar portion of the die attach paddle forms a first ground plane inside the semiconductor package above the at least one semiconductor die,
the printed circuit board comprising:
- a plurality of pin pads configured to join the leads electrically and mechanically to the printed circuit board, and
- a second ground plane electrically coupled to the at least two first leads, wherein the second ground plane is disposed on the face of the printed circuit board that resides towards the semiconductor package, wherein the second ground plane is coplanar with the plane of the die attach paddle, and wherein a first part of the second ground plane is disposed under the body of the semiconductor package.

2. The semiconductor assembly of claim 1, wherein the area of the first part of the second ground plane covers at least a majority of the area of an orthogonal projection of the semiconductor package body on the essentially planar printed circuit board.

3. The semiconductor assembly of any of claims 1 to 2, wherein the shape of the first part of the second ground plane is essentially similar to the shape of the orthogonal projection of the body of the semiconductor package on the essentially planar printed circuit board.

4. The semiconductor assembly of any of claims 1 to 2, wherein the first part of the second ground plane extends outside of the area covered by the projection of the body of the semiconductor package on at least one side of the semiconductor package, which at least one side has no leads.

5. The semiconductor assembly of any of claims 1 to 4, wherein the second ground plane further comprises at least two extensions configured to provide at least two pin pads for coupling the at least two first leads to the second ground plane.

6. The semiconductor assembly of any of claims 1 to 5, wherein the at least one semiconductor die comprises at least one MEMS die.

7. A semiconductor package configured to be assembled in a semiconductor assembly according to any of claims 1 to 6.
